(19) **Europäisches Patentamt / European Patent Office / Office européen des brevets**

(11) **EP 4 104 292 B1**

(12) **EUROPEAN PATENT SPECIFICATION**

(45) Date of publication and mention
of the grant of the patent:
**28.08.2024 Bulletin 2024/35**

(21) Application number: **20705196.2**

(22) Date of filing: **14.02.2020**

(51) International Patent Classification (IPC):
**H03K 17/0814** (2006.01)   **H02H 3/093** (2006.01)
**H03K 17/14** (2006.01)   **H02H 3/08** (2006.01)
**H03K 17/18** (2006.01)   **H02H 7/20** (2006.01)
**H02H 6/00** (2006.01)   **H02H 7/22** (2006.01)
**H03K 17/08** (2006.01)   **H03K 17/082** (2006.01)

(52) Cooperative Patent Classification (CPC):
**H03K 17/082; H02H 6/00; H02H 7/222;**
H02H 3/0935; H03K 2017/0806

(86) International application number:
**PCT/EP2020/053904**

(87) International publication number:
**WO 2021/160285 (19.08.2021 Gazette 2021/33)**

(54) **METHOD OF PROTECTING RELAYS OR ELECTRONIC SWITCHES FROM OVERHEATING BY CREEPING SHORT CIRCUIT CURRENTS**

VERFAHREN ZUM SCHUTZ VON RELAIS ODER ELEKTRONISCHEN SCHALTERN VOR ÜBERHITZUNG DURCH KURZSCHLUSSKRIECHSTRÖME

PROCÉDÉ DE PROTECTION DE RELAIS OU DE COMMUTATEURS ÉLECTRONIQUES CONTRE LA SURCHAUFFE PAR FLUAGE DE COURANTS DE COURT-CIRCUIT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.12.2022 Bulletin 2022/51**

(73) Proprietor: **HELLA GMBH & CO. KGAA**
**59552 Lippstadt (DE)**

(72) Inventors:
• **DUMITRESCU, Teodor Gabriel**
**Vinju Mare (RO)**
• **FLORICA, Tudor Nicusor**
**Mun. Craiova (RO)**
• **SCHMÄLING, Jan**
**97769 Bad Brückenau (DE)**
• **VANA, Petre Emanuel**
**Mun. Craiova (RO)**

(56) References cited:
**US-A1- 2015 022 930**    **US-A1- 2015 022 930**
**US-A1- 2015 138 682**    **US-A1- 2015 138 682**

## Description

The invention relates to a method of protecting relays or electronic switches from overheating or thermal damage due to creeping short circuit currents. Protection of the electronic circuits against thermal damage is disclosed in documents US 2015/138682 A1 and US 2015/022930 A1.

The creeping short circuit which was meant is:
During active or inactive circuit, a possible creeping short could occur at the output pin which is sup-plied by the relay or electronic switch. During inactive circuit the creeping short circuit current is not critical, but it could be critical if the current is close failure threshold after activation and no short circuit will be detected. The creeping short circuit current is then below the tolerance dependent failure threshold and could lead (dependent on the current) to an immediate and possibly permanent failure of the relay or electronic switch.

Such creeping short-circuit currents may not directly affect the function of the relay or electronic switch and the circuit in which they are used. However, a permanent creeping short-circuit current can lead to a thermal load that damages or destroys the relay or electronic switch.

Whether a creeping short-circuit current and when a creeping short-circuit current damages or destroys the relay or electronic switch depends on the level of the short-circuit current or on the duration of the short-circuit current. The progression of the creeping short-circuit current also plays a role. For example, whether it rises or falls. These factors as well as parameters and environmental parameters specific to the component influence the time the component can withstand the creeping short-circuit current without being damaged or destroyed. If the current is switched off or the load is reduced in time before the component can withstand the creeping short-circuit current, damage or destruction of the component can be avoided.

The invention is based on the task of determining when the current must be switched off or the load reduced in order to prevent damage or destruction of the relay or electronic switch due to a creeping short-circuit current.

To solve this task, the following method of protecting relays or electronic switches from overheating by creeping short circuit currents is proposed, in which the following steps are carried out in a loop

- Measurement of the short circuit current at a measurement time,
- Determination of a load time period for which the relay or switch could continue to be loaded with the measured short-circuit current from the time of measurement without being damaged or destroyed, not taking into account any loading of the relay or switch before entering the loop,
- Determination of a characteristic value, by forming the ratio of a measurement interval duration and the load time period,
- Formation of the sum of the characteristic value and a sum determined during a previous run of the loop,
- Comparison of the sum with a lo load limit value,
- Generation of a signal that indicates that a load limit has been reached if the sum reaches or exceeds the load limit value.

There are several ways to determine the load time period.

For example, it is possible to set up an equation for the load time period in which the measured short-circuit current is entered as a variable. The equation can include parameters specific to the component, parameters typical for the environment in which the component is to be used (environment parameters), parameters typical for the operation of the component or other parameters that have been defined in advance. A component-specific parameter is the thermal resistance between the junction of an electronic switch and the environment. In the case of an electronic switch, for example a MOSFET, component-typical parameters can be the resistance between the drain and source, in particular a typical drain-source resistance at an ambient temperature of 25°C or a maximum drain-source resistance at an ambient temperature of 25°C which are set when the electronic switch is switched on. Typical operating parameters can be, for example, the maximum ambient temperature set for the intended use or the maximum temperature of the dies set for the operation.

The drain-source resistance can be current dependent. In addition, the rate of change of the drain-source resistance which changes as a function of the current can be a parameter typical of the component.

The drain-source resistance can also be temperature-dependent. In addition, the rate of change of the drain-source resistance which changes as a function of temperature can be a parameter typical of the component.

In addition, it is possible to define a look-up table in advance, possibly with the help of the above equation in which a load time period is specified for the measured short-circuit current. From this table, the load time period for a measured short-circuit current can be determined, if necessary, with the aid of an approximation of the load time period.

By forming the characteristic value, i.e. by forming the ratio of a measurement interval duration and the load time period, and by forming the sum of the characteristic value and a sum determined during a previous loop run, the load on the component in the period before the measurement time is taken into account when determining the further load-bearing capacity. By forming the characteristic value, it is determined, for example, what percentage of the load-bearing capacity time duration determined in the loop run has passed through the measuring interval duration, i.e. since the previous loop run. The characteristic value indicates the percentage of the duration of the load time period that has already passed since the last loop pass.

These characteristic values are determined for each loop pass. The consumption of the determined load time period in each measuring interval is summed up. If the characteristic value is given in percent, the result is a sum of percentages.

The sum is then compared with a load limit value. If the characteristic values or the sum of the characteristic values is given in percent, the load limit value can also be given in percent. It can be 100%, for example. This can be understood to mean that due to the change in thermal load up to the loop pass where 100% is reached, the cumulative thermal load on the component has reached a level at which further thermal load could damage or destroy the component. It then makes sense to avoid further thermal stress on the component and to switch off any current flowing through the component. The current to be switched off may be the current carried by the relay or electronic switch when closed.

In order to understand the invention, it may be helpful to be aware that both the load time period and the load limit value are not physically measurable characteristics of the relay or electronic switch. Rather, the two quantities are quantities invented by the inventors, which are based on technical considerations regarding the effects of currents on the heating of the components.

The procedure according to the invention can be further developed in various ways.

For example, before the sum is formed, the load time period can be compared with a time limit value. If the load time period is shorter than the time limit value, summation can then take place and if, on the other hand, the load time period is longer than the time limit value, the characteristic value can be set to zero and summation can then take place, which means that the sum is not increased and the further load capacity is not reduced. The time limit value is advantageously chosen in such a way that when the time limit value is reached, the load time period is so long that the component can be loaded with the measured current for an unlimited period of time without suffering damage. In this case, it is not necessary to increase the sum since nothing of the time that the component may be exposed to a load is then consumed.

Before comparing the sum with the load limit value, it can be checked whether the sum has increased during a first period of time. If the sum has not increased, the sum can be set to zero, and if the sum has increased, the sum can remain unchanged. This first time period is longer than the time that elapses between two current measurements. It is advantageous that the first time period is several times longer than the time between two measurements. The first time period may be determined depending on the characteristic value. The higher the characteristic value, the longer the first time period could be. This further development of the method according to the invention makes it possible to reset the sum to zero if, for example, the current that is applied to the component has been reduced or has ceased to exist. The sum is then not only not increased any further, but can also be set to zero, since the component can be fully loaded again.

After further improvement of the invention, if the sum before returning to the beginning of the loop does not reach or falls below the load limit value, the sum can be compared with a measure limit value. If the measure limit value is exceeded, at least one measure to reduce the thermal power can be taken before returning to the beginning of the loop. For example, the current conducted via the relay or the electronic switch can be reduced, while if the measure limit value is not reached, the system returns to the start of the loop without further measures. The current through the electronic switch could be reduced by using modulation techniques such as PWM or by adjusting duty cycles.

Summary

The invention is defined by the features of independent claims. Preferred embodiments are set out in the dependent claims.

Detailed Description

On the basis of the attached drawing, the invention is explained in more detail below. Thereby shows:

Fig. 1      an example of the development of a creeping short circuit current
Fig. 2      the drain-source-resistance in on-state dependent of the drain current at a gate-source voltage of 10V
Fig. 3      the drain-source-resistance in on-state dependent of the temperature at a drain current of 30A and a gate-source voltage of 10V
Fig. 4      thermal characteristics of the electronic switch used as example dependent of a pulse time,
Fig. 5      the load time period t_actual dependent on the creeping short circuit current I_meas
Fig. 6a      a profile of a creeping short circuit current Imeas of a first example

Fig. 6b    the sum of the characteristic values of the first example with the given creeping short circuit current Imeas profile

Fig. 7a    a profile of a creeping short circuit current Imeas of a second example

Fig. 7b    the sum of the characteristic values of the second example with the given creeping short circuit current Imeas profile

Fig. 8a, b    a flowchart of a process according to the invention.

The implementation for a short circuit detection according the state of the art is typically done for high-side or low-side drivers (HSD, LSD) at several applications in automotive or consumer electronics with a defined short circuit current threshold. The threshold is based on calculations by using the datasheet parameters and the maximum required current. The calculated short circuit current threshold is then caused by tolerances between 20 to 50% far away from the typical current.

Between the typical current and the short circuit current threshold the output will work because the short circuit detection will not detect a fault, neither a short to plus (S2P) nor a short to ground (S2G).

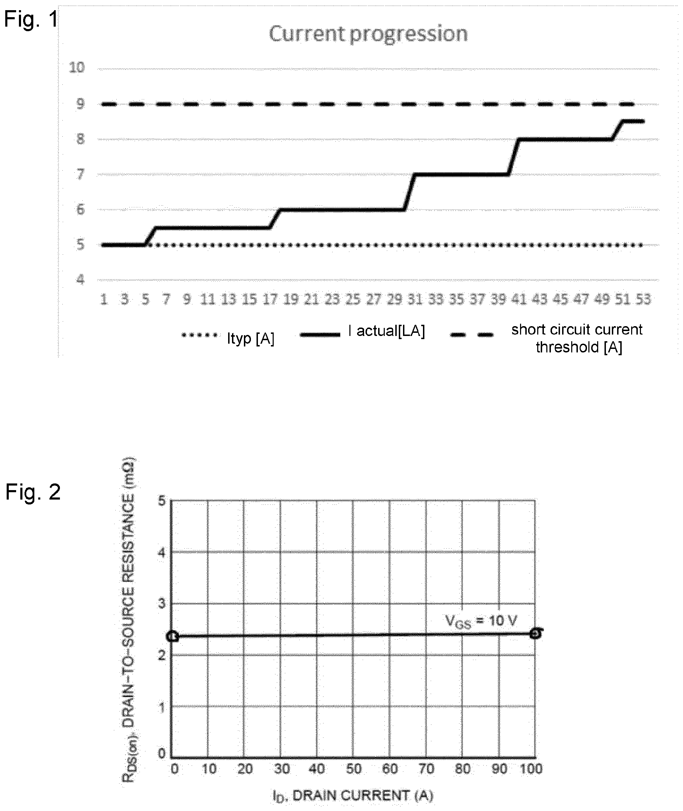

A problem is that a slow increased current or a constantly present current smaller than the short circuit current threshold, e.g. a creeping short circuit, could cause a thermal load based on the time how long the fault is present. An example for a slowly increasing creeping short circuit current I_present smaller than a short circuit current threshold I_fault but higher than a typical current Ityp is shown in figure 1. The increasing current causes an increasing self-heating, depending e.g. on the creeping short circuit current I_meas and used relay or electronic switch.

A problem could be, e.g. during motor control, that the motor stuck at a higher current consumption position (but below the short circuit current threshold) and increase the temperature of the switching element.

In order to avoid the thermal problems or damage of the component the following invention was accomplished.

The ideas behind the example shown in the figures are

- to figure out the capability to carry a thermal load caused by creeping short circuit current I_Meas out of datasheet parameters and project related parameters of the component. That means determining the possible time to carry the increased current I_Meas without thermal damage of the component.
- to figure out a formula that could implemented in a software for the calculation of the load time period t_actual of the component to carry the actual creeping short circuit current.
- to calculate a load time period t_actual with the help of the formula depending on the measured creeping short circuit current I_Meas.
- to determine a characteristic value Prog(t) [Prog(t) means the progress of the loeading time period] expressing a percental progress of the overall time with increased current depending on a measurement interval duration t_meas and the load time period t_actual.
- if the calculated load time period t_actual sets no limitation to the capability to carry the actual creeping short circuit current, the characteristic value Prog(t) will be set to 0.
- to summarize all characteristic values Prog(t).
- if the sum Sum_Prog_t of the characteristic values Prog(t) is unchanged since a defined time T_unchanged, the sum Sum_Prog_t will be reset.
- if the Sum Sum_Prog_t is >= 100%, the component is to protected with a shut off.
- if the sum is below 100% but above one or several defined measure limit values TH_Protection, a protection routine with e.g. PWM or/and duty cycle adjustment could be used.

Before the example of a method of protecting relays or electronic switches from overheating by creeping short circuit currents according to these ideas could be implemented in a software of a controller the formula for the calculation has to be derived.

Based on part parameters from Datasheet, a calculation of the load time period for an increased current can be done. All following parameters are an example for calculation. The target is to implement a simplified formula in a software.

The formula will be developed with several initial data from Datasheet or project related information. The example is done for a power MOSFET of the type NVMFD5C446N. That means that the parameters typical for the electronic switch are taken from the datasheet of NVMFD5C446N. Several parameters are taken from the datasheet, others are related to the intended use of the Power MOSFET:

a) Drain-source-resistance in on-state

RDSON that means the resistance of a drain-source-path when the MOSFET is switched on. The parameters are figured out of the datasheet for ambient temperature of 25°C and a typical current ($R_{DSon\_25C\_typ}$) and a maximal current ($R_{DSon\_25C\_max}$).

From the resistances for a typical current ($R_{\text{DSon\_25C\_typ}}$) and a maximal current ($R_{\text{DSon\_25C\_max}}$) a parameter

$$K_{max/typ} = \frac{R_{\text{DSon\_25C\_typ}}}{R_{\text{DSon\_25C\_max}}} \quad \text{is derived.}$$

| | | |
|---|---|---|
| $R_{\text{DSon\_25C\_typ}}$ | 2,40 | mOhms |
| $R_{\text{DSon\_25C\_max}}$ | 2,90 | mOhms |
| $K_{max/typ} = \dfrac{R_{\text{DSon\_25C\_typ}}}{R_{\text{DSon\_25C\_max}}}$ | 1,21 | |

b) Junction-to-ambient-thermal resistance in a steady state

| | | |
|---|---|---|
| $R_{\text{thA\_typ}}$ | 47,00 | °C/W |

c) Maximum ambient temperature (depending on intended use)

| | | |
|---|---|---|
| Tamb | 85,00 | $^0$C |

d) Maximum die temperature for the Power MOSFET (depending on intended use)

| | | |
|---|---|---|
| Tmax | 150,00 | $^0$C |

e) Drain-Source-Resistance in on-state / Drain current vs. Gate voltage

Figure 2 shows a dependency of the drain-source-resistance in on-state of the drain current at a gate-source voltage of 10V. Form this figure the parameters $R_{\text{DSon\_Imin}}$, $I_{min}$, $R_{\text{DSon\_Imax}}$, $I_{max}$ are taken. A gradient

$$m_{RDson} = \frac{RDSon_{Imax} - RDSon\_Imin}{Imax - Imin} \quad \text{is derived:}$$

| | | |
|---|---|---|
| $R_{\text{DSon\_Imin}}$ | 2,35 | mOhms |
| $I_{min}$ | 0 | A |
| $R_{\text{DSon\_Imax}}$ | 2,45 | mOhms |
| $I_{max}$ | 100 | A |
| $m_{RDson} = \dfrac{RDSon_{Imax} - RDSon\_Imin}{Imax - Imin}$ | 0,001 | mOhms /A |

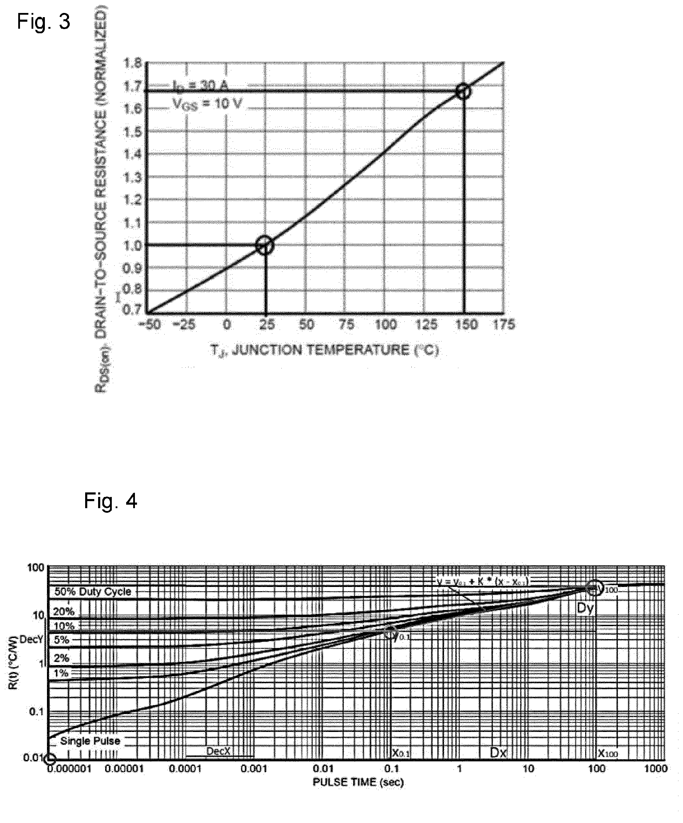

f) Variations of the normalized drain-source-resistance in on-state RDson Figure 3 shows a dependency of the Drain-Source-Resistance in on-state of the temperature at a drain current of 30A and a gate-source voltage of 10V. Form this figure the parameters $R_{\text{DSon\_Tmin}}/R_{\text{DSon\_25C}}$, $T_{25C}$ and $R_{\text{DSon\_Tmax}}/R_{\text{DSon\_25C}}$ are taken. Tmax is known from d). A

gradient $m_{Temp} = \dfrac{\frac{RDSon_{Tmax}}{RDSon_{25C}} - \frac{RDSon_{Tmin}}{RDSon_{25C}}}{Tmax - T25C}$ is derived from these parameters.

| | | |
|---|---|---|
| $R_{\text{DSon\_Tmin}}/R_{\text{DSon\_25C}}$ | 1 | |
| T25c | 25 | $^0$C |

(continued)

| $R_{DSon\_Tmax}/R_{DSon\_25C}$ | 1,67 | |
|---|---|---|
| Tmax | 150 | $^0$C |
| $m_{Temp} = \dfrac{\dfrac{RDSon_{Tmax}}{RDSon_{25C}} - \dfrac{RDSon_{Tmin}}{RDSon_{25C}}}{Tmax - T25C}$ | 0,00536 | $^0$C$^{-1}$ |

g) Thermal Characteristic of the Power MOSFET

The parameters are coming through measurement with a ruler of figure 4. Because the diagram is a double logarithmic diagram a linearization of the curve for the used component is performed as marked in figure 4. For this purpose, the unit [mm] is used.

| DecY | 21 | mm |
|---|---|---|
| $y_{min} = DecY * \lg\left(\dfrac{R_{0,1}}{R_0}\right)$ | 54,64 | mm |
| $y_{max} = = DecY * \lg\left(\dfrac{R_{100}}{R_0}\right)$ | 74,43 | mm |
| $Dy = y_{max} - y_{min} = DecY * \lg\left(\dfrac{R_{100}}{R_{0,1}}\right)$ | 19,78 | mm |
| $R_0$ | 0,01 | °C/W |
| $R_{0,1}$ | 4 | °C/W |
| $R_{100}$ | 35 | °C/W |
| | | |

| DecX | 28,5 | mm |
|---|---|---|
| $x_{min} = DecX * \lg\left(\dfrac{t_{0,1}}{t_0}\right)$ | 142,5 | mm |
| $x_{max} = DecX * \lg\left(\dfrac{t_{100}}{t_0}\right)$ | 228 | mm |
| $Dx = x_{max} - x_{min} = DecX * \lg\left(\dfrac{t_{100}}{t_{0,1}}\right)$ | 85,5 | mm |
| $t_0$ | 0,000001 | s |
| $t_{0,1}$ | 0,1 | s |
| $t_{100}$ | 100 | s |
| $K = D_y/D_x$ | 0,23137 | |

The formulas table before are used to calculate the needed values (see also the calculation at 3 below). Because of component dependencies the way how to calculate it differs between each used electronic switch. The following calculation or value determination is an example for the NVMFD5C446N.

With all these values a timing for increased current carrying capability calculation is possible with the dependency to RDson, Rth, thermal characteristics and project related parameters.

For the following example, a current of Imeas = 10A is used.

(1) Calculation of the RDson dependent on the temperature increase caused by the current

$$R_{DSon}[m\Omega] = K_{Max/typ} * R_{DSon\_Tmax}/R_{DSon\_25C} * (m_{RDson} * (Imeas - Imin) + R_{DSon_{Imin}})$$

$$R_{DSon}[m\Omega] = 1{,}21 * 1{,}67 * (0{,}001\frac{m\Omega}{A} * (Imeas - 0A) + 2{,}35m\Omega)$$

$$R_{DSon}[m\Omega] = 2{,}0207 * \left(0{,}001\frac{m\Omega}{A} * 10A + 2{,}35m\Omega\right)$$

$$R_{DSon}[m\Omega] = 4{,}76885m\Omega$$

(2) Power dissipation caused by RDson

$$P_{MOSFET} = R_{DSon}[\Omega] * I^2$$

$$P_{MOSFET} = 0{,}00477\Omega * (10A)^2$$

$$P_{MOSFET} = 0{,}00477\Omega * 100A^2$$

$$P_{MOSFET} = 0{,}4769W$$

(3) Thermal resistance based on power dissipation

$$R(t) = MIN\left[\frac{T_{\max} - T_{25C}}{P_{MOSFET}}; R_{thA_{typ}}\right]$$

$$R(t) = MIN\left[\frac{150°C - 25°C}{0{,}477W}; 47\frac{°C}{W}\right]$$

$$R(t) = MIN\left[262{,}05\frac{°C}{W}; 47\frac{°C}{W}\right]$$

For R(t) is the minimum value for further calculations valid
(4) Include thermal behavior of the Power MSOFET

$$y = DecY * \lg\left(\frac{R(t)}{R_0}\right)$$

$$y = 21mm * \lg\left(\frac{MIN\left[\frac{T_{\max} - T_{25C}}{P_{MOSFET}}; R_{thA_{typ}}\right]}{0{,}01\frac{°C}{W}}\right.$$

$$y = 21mm * \lg(4700) = 77{,}114mm$$

$$y_{min} = DecY * \lg\left(\frac{R_{0,1}}{R_0}\right)$$

$$y_{min} = 21mm * \lg\left(\frac{4\frac{°C}{W}}{0{,}01\frac{°C}{W}}\right)$$

$$y_{min} = 54{,}64mm$$

$$x_{min} = DecX * \lg\left(\frac{t_{0,1}}{t_0}\right)$$

$$x_{min} = 28{,}5mm * \lg\left(\frac{0{,}1s}{0{,}000001s}\right)$$

$$x_{min} = 142{,}5mm$$

$$k = D_y/D_x$$

$$k = DecY * \lg\left(\frac{R_{100}}{R_{0,1}}\right)\Big/ DecX * \lg\left(\frac{t_{100}}{t_{0,1}}\right)$$

$$k = 21mm * \lg\left(\frac{35\frac{°C}{W}}{4\frac{°C}{W}}\right)\Big/ 28{,}5mm * \lg\left(\frac{100s}{0{,}1s}\right)$$

$$k = 19{,}78mm/85{,}5mm$$

$$k = 0{,}2313$$

By rearranging and solving the equation $y = y_{min} + k * (x - x_{min})$ to $x$, one obtains an equation for $x$ and insert the values caculated for $x_{min}$, $y_{min}$, $y$, and $k$.

$$x = x_{min} + \frac{y - y_{min}}{k}$$

$$x = 142{,}5mm + \frac{77{,}114mm - 54{,}64mm}{0{,}2313}$$

$$x = 239{,}62mm$$

Now a x value for the normalized double logarithmic diagram (fig. 4) in [mm] is available. From this x value with values from g) the time $t$ which is related to the $x$ value can be calculated.

(5) Calculation of the possible time to withstand the increased current based on calculations

$$t = t_0 * 10^{\frac{x}{DecX}}$$

$$t = 0{,}000001s * 10^{\frac{239.62mm}{28{,}5mm}}$$

$$t = 255{,}702s$$

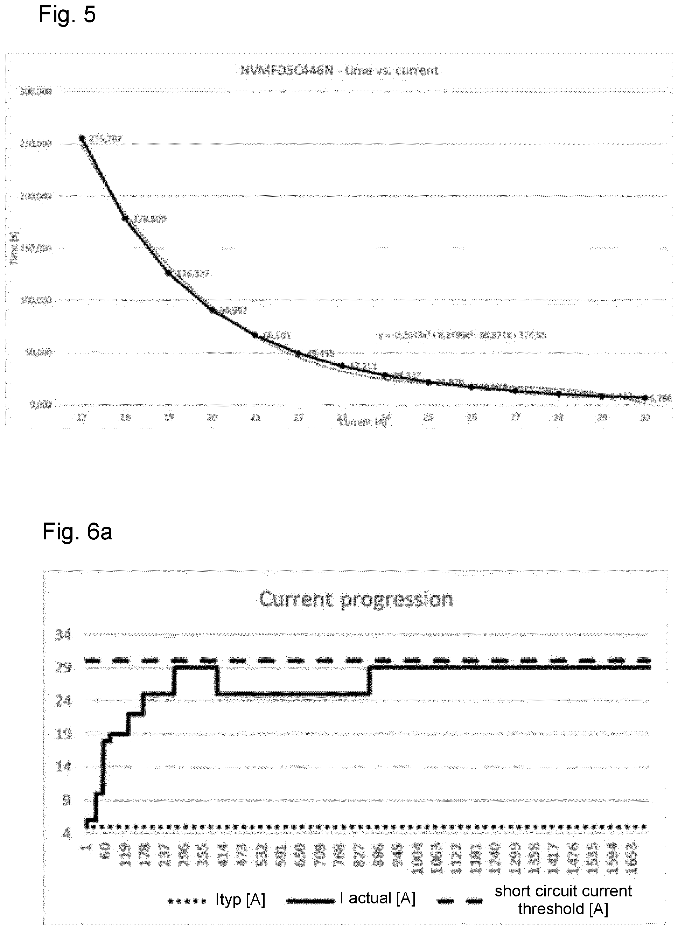

From equation $t = t_0 * 10^{\frac{x}{DecX}}$ the load time period t_actual, for which the component withstands the creeping short circuit current is calculated. If the creeping short circuit current increases, the time will decrease (see fig. 5). A calculated timing of 255 seconds or more means per definition that the relay or electronic switch can carry the thermic load without any risk of damage or destruction of the component. The value 255 seconds will be realized for a current without thermal effect by using in (3) always the minimum value of the thermal resistance.

The following table will show as an example for several currents the related calculation result (the Imeas value from example above is now replaced by the values from the first column).

| Imeas [A] | $R_{DS\_on}$ [mOhms] | $P_{MOSFET}$ [W] | R(t) [$^0$C/W] | y | x | t_actual [s] |
|---|---|---|---|---|---|---|
| 1 | 4,75067 | 0,0048 | 47,00 | 77,114 | 239,620 | 255,702 |
| 17 | 4,7830 | 1,3823 | 47,00 | 77,114 | 239,620 | 255,702 |
| 18 | 4,7850 | 1,5503 | 41,93 | 76,072 | 235,117 | 177,719 |
| 19 | 4,7870 | 1,7281 | 37,61 | 75,082 | 230,838 | 125,773 |
| 20 | 4,7891 | 1,9156 | 33,93 | 74,143 | 226,778 | 90,598 |
| 21 | 4,7911 | 2,1129 | 30,76 | 73,249 | 222,915 | 66,309 |
| 22 | 4,7931 | 2,3199 | 28,02 | 72,396 | 219,231 | 49,239 |
| 23 | 4,7951 | 2,5366 | 25,62 | 71,582 | 215,710 | 37,048 |
| 24 | 4,7971 | 2,7632 | 23,52 | 70,802 | 212,338 | 28,213 |
| 25 | 4,7992 | 2,9995 | 21,67 | 70,053 | 209,103 | 21,724 |
| 26 | 4,8012 | 3,2456 | 20,03 | 69,334 | 205,994 | 16,900 |
| 27 | 4,8032 | 3,5015 | 18,56 | 68,642 | 203,003 | 13,271 |
| 28 | 4,8052 | 3,7673 | 17,25 | 67,975 | 200,119 | 10,513 |
| 29 | 4,8072 | 4,0429 | 16,08 | 67,331 | 197,336 | 8,396 |
| 30 | 4,8093 | 4,3283 | 15,02 | 66,708 | 194,647 | 6,756 |

This calculation is only one possible way to calculate and serves as an example to show the influence of the measured current Imeas to the load time period t_actual for carrying the increased current without thermal damage.

The equation $t = t_0 * 10^{\frac{x}{DecX}}$ needed for the calculation of t_actual will be implemented in a software as simplified as possible.

The information of the calculated time will be used to determine possible problems for the component and to have the possibility for a reaction to reduce the influence or to switch off the circuit with component.

The t_actual does not take into account any development before the measurement of the creeping short circuit current Imeas. Therefore, the heating of the component before the measurement time has to be considered. Therefore the characteristic value Prog(t)=T_actual/t_meas expressing a percental progress of the overall time with increased current depending on a measurement interval duration t_meas and the load time period t_actual is defined. Then the characteristic values Prog(t) are summed up to get Sum_Prog_t which represent the elapsed progress. Considering the elapsed progress Sum_Prog_t gives the possibility of an estimation about the allowed further load.

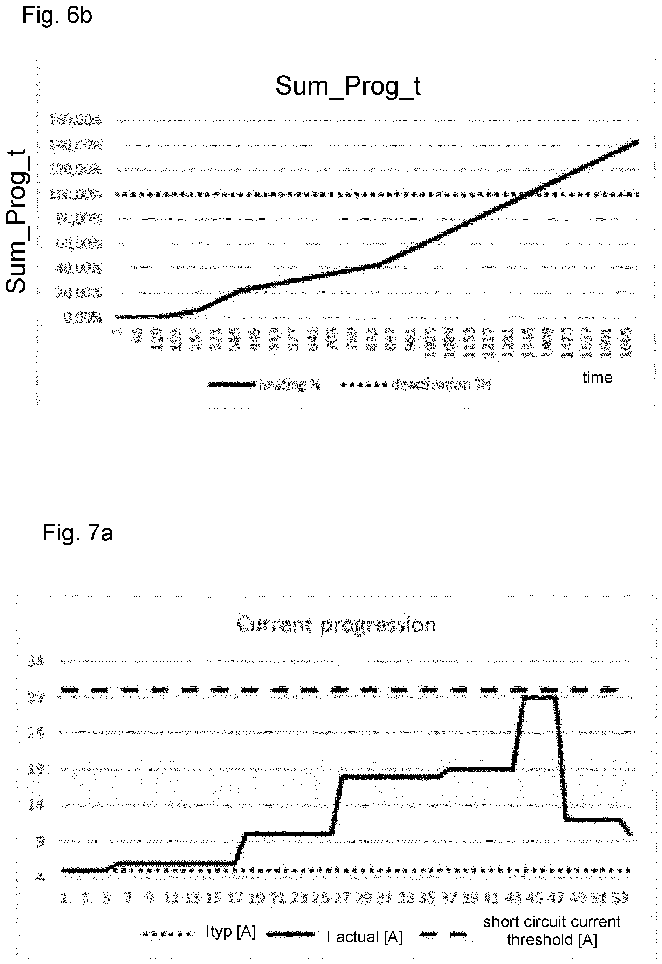

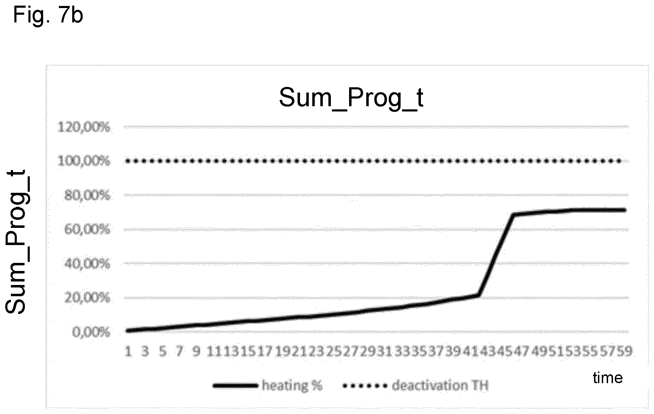

For two examples of given creeping short circuit current Imeas profiles (see fig. 6a, 7a) the calculations of the progression of the heating is done. The results are shown in fig. 6b, 7b).

Example 1 (fig. 6a, 6b, increasing creeping short circuit current Imeas, measurement interval duration t_meas = 10 ms):

After calculating as described above, eventually the 100% are reached and a shut of is needed for thermal protection of the component. The following table shows an extract with values shown in fig. 6a, 6b.

| t [s] | I_meas [A] | T_actual | Prog(t) | Sum_Prog_t |
|---|---|---|---|---|
| 0,01 | 5 | 255,7024 | 0,00% | 0,00% |
| 0,17 | 6 | 255,7024 | 0,00% | 0,00% |
| 0,37 | 10 | 255,7024 | 0,00% | 0,00% |
| 0,58 | 18 | 178,5004 | 0,01% | 0,01% |
| 0,85 | 19 | 126,3268 | 0,01% | 0,18% |
| 1,46 | 22 | 49,45531 | 0,02% | 0,86% |
| 3,87 | 29 | 8,432762 | 0,12% | 19,74% |
| 4,17 | 25 | 21,81997 | 0,05% | 21,99% |
| 10,84 | 29 | 8,432762 | 0,12% | 68,79% |
| 10,85 | 29 | 8,432762 | 0,12% | 68,90% |

Different strategies for reaction are possible for reaching a defined limit or "healing" if the device is for a defined time in a relaxed condition (t =255 calculated).

Example 2 (fig. 7a, 7b, short time hanging motor or short time over current, (t_meas = = 1s)

The %-progression (see fig. 7b) for example 2 shows that a high creeping short circuit current for a short time does not lead to a reduced activation time of the component.

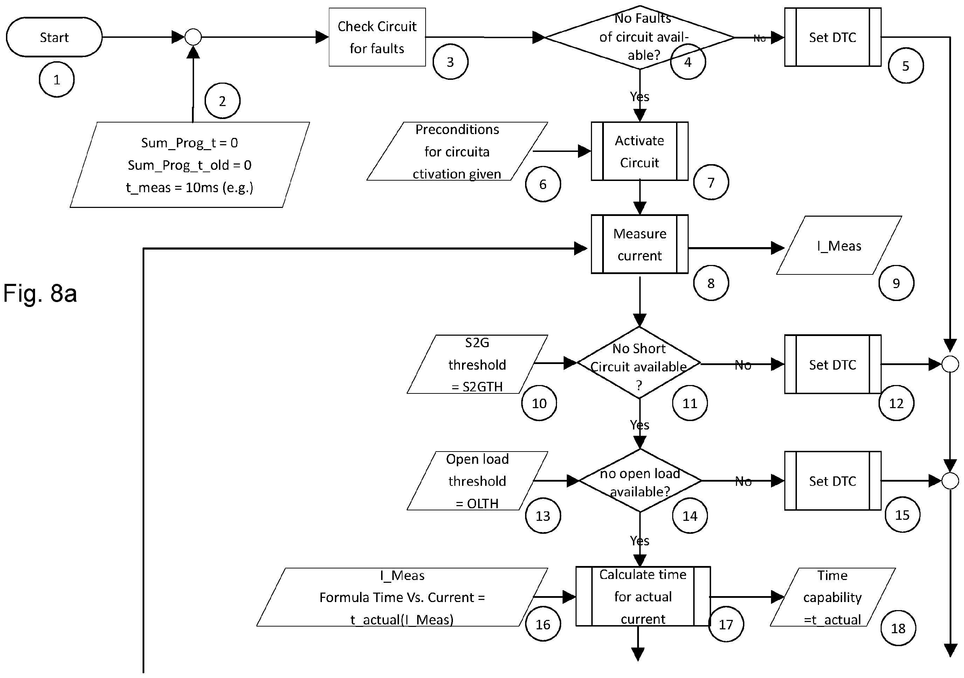

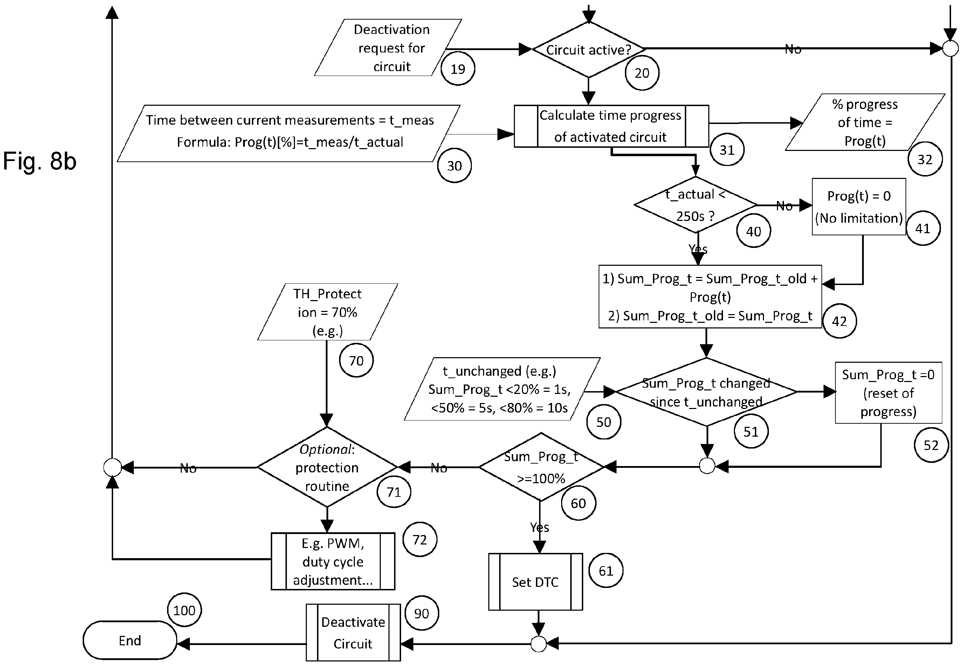

The flow chart in Fig. 8 shows one implementation for the detection of creeping current and possible reactions.

The routine starts at step 1 with an initialization at step 2 of the variables Sum_Prog_t, Sum_Prog t old and setting of t_meas for example to 10 ms and the check 3, 4 of already existing faults like short to battery or communication faults.

If no fault is present, the circuit will be activated at step 7 if the further relevant preconditions 6 are given. If a fault is present a diagnostic trouble code (DTC) will be set at step 5.

After activation of the circuit at step 7, a measurement of creeping short circuit current I_meas will be performed at step 8 and the measured value I_meas will be stored in a memory in step 9. At step 8, a loop begins which is passed several times during the active time of the circuit.

A short circuit analysis will be performed at step 11 by a comparison with a S2G threshold at step 10. If there is a S2G, a DTC will be set at step 12 and the circuit will be disabled at step 90. The same procedure will be done with an open load threshold at steps 13, 14. In the case of detection of an open load a DTC will be set at step 15 and the circuit will be disabled at step 90. Depended on the application a different handling of the detection of an open load is possible.

With the (step 16) given equation for t_actual and the measured current I_meas, at step 17 the calculation of the time capability of the switching element to carry the measured current (18) will be performed.

If there is a deactivation request available at step 19, a check will be done if the circuit is active (step 20). If a shut off is requested (NO decision), the circuit will be deactivated at step 90.

The circuit is still active and no deactivation requested the progress of the circuit is considered in steps 30, 31, 32 by determining the characteristic value Prog(t).

In case of a calculated progress time t_actual above a limit, which is checked in step 40, the progress will be defined with "no limitation" in step 41 and the characteristic value Prog(t) will be reset, which means that with the actual measured creeping short circuit current I_meas there is no risk of overheating for the component.

The summation of the previous sum of the characteristic values sum_prog t old and the present characteristic value Prog(t) will be done at step 42.

If the sum of the characteristic values is unchanged for a defined time T_unchanged (which may be dependent on the sum of the characteristic values sum_prog_t, (at step 50), the sum of the characteristic values sum_prog_t will be reset because there is no risk of overheating of the component (steps 51, 52). This is implemented to recover the counter sum_prog_t and ensure a continuous activation during active request for enabled output.

If the sum of the characteristic values sum_prog_t is above 100% (step 60), a DTC is set at step 61 and the circuit will be deactivated at step 90.

In case of an implemented optional protection routine (step 71) with one or more defined measure limit values, a protection routine will be defined at step 70 and the power dissipation of the switching element will be optimized at step 72 with e.g. by PWM usage or duty cycle adjustment.

Then the loop starts again with a new current measurement at step 8.

After deactivation of the circuit at step 90 the routine is finished (step 100).

## Claims

1. Method of protecting relays or electronic switches from overheating or damage by creeping short circuit currents, wherein the following steps carried out in a loop

   - measurement of the creeping short circuit current at a measurement time (8),
   - determination of a load time period (17) for which the relay or switch could continue to be loaded with the measured creeping short circuit current from the time of measurement without being damaged or destroyed, not taking into account a loading of the relay or switch before entering the loop,
   - determination of a characteristic value (32), by forming the ratio of a measurement interval duration and the load time period,
   - formation of the sum of the characteristic value and a sum determined during a previous run of the loop (42),
   - comparison of the sum with a load limit value (60),
   - generation of a signal that indicates that a load limit value has been reached if the sum reaches or exceeds the load limit value (61),
   - return to the beginning of the loop if the sum has not reached or falls below the load limit value (71, 8).

2. Method according to claim 1, wherein before the sum is formed,
   the duration of the load time period is compared with a time limit value (40) and if the load time period is less than the time limit value, the formation of the sum takes place (42) and if the load time period is higher than the time limit value, the characteristic value is set to zero (41) and the formation of the sum then takes place (42).

3. Method according to claim 1 or 2, wherein before comparing
   the sum with the load limit value it is checked whether the sum has increased during a first time period (51) and if the sum has not increased the sum is set to zero (52), but if the sum has increased, the sum remains unchanged.

4. Method according to claim 3 wherein the first time period is determined depending on the characteristic value (50).

5. Method according to one of the claims 1 to 4, wherein if the sum does not reach or falls below the load limit value before returning to the start of the loop, the sum is compared with a measure limit value (71) and if the measure limit value is exceeded before returning to the start of the loop measures are taken to reduce the average current conducted through the relay or the electronic switch (72), while, if the measure limit value is not reached, it is returned to the start of the loop (8).

6. Method according to one of the claims 1 to 5, wherein for an electronic switch the load time period is determined as a function of the thermal resistance between the junction of the electronic switch and the environment.

7. Switching device comprising a relay or an electronic switch, a current sensor inside the relay or electronic switch or outside the relay or electronic switch, and a controller having an output connected to a control input of the relay or electronic switch and an input connected to the current sensor, the controller being arranged to execute the method according to any one of claims 1 to 6.

**Patentansprüche**

1. Verfahren zum Schutz von Relais oder elektronischen Schaltern vor Überhitzung oder Beschädigung durch Kurzschlusskriechströme,
   wobei die folgenden Schritte in einer Schleife ausgeführt werden:

   - Messen des Kurzschlusskriechstroms zu einer Messzeit (8),
   - Bestimmen eines Lastzeitraums (17), für den das Relais oder der Schalter ab dem Zeitpunkt der Messung auch weiterhin mit dem gemessenen Kurzschlusskriechstrom belastet bleiben könnte, ohne dass es/er beschädigt oder zerstört wird, wobei ein Belasten des Relais oder Schalters vor dem Eintreten in die Schleife nicht berücksichtigt wird,
   - Bestimmen eines Kennwertes (32) durch Bilden des Verhältnisses zwischen der Dauer eines Messintervalls und dem Lastzeitraum,
   - Bildern der Summe des Kennwertes und einer Summe, die durch einen vorhergehenden Lauf der Schleife (42) bestimmt wurde,
   - Vergleichen der Summe mit einem Lastgrenzwert (60),
   - Erzeugen eines Signals, das angibt, dass ein Lastgrenzwert erreicht wurde, wenn die Summe den Lastgrenzwert (61) erreicht oder überschreitet,
   - Zurückkehren zum Anfang der Schleife, wenn die Summe nicht erreicht wurde oder unter den Lastgrenzwert (71, 8) fällt.

2. Verfahren nach Anspruch 1, wobei, bevor die Summe gebildet wird, die Dauer des Lastzeitraums mit einem Zeitgrenzwert (40) verglichen wird, und wenn der Lastzeitraum kleiner als der Zeitgrenzwert ist, erfolgt (42) die Bildung der Summe, und wenn der Lastzeitraum höher als der Zeitgrenzwert ist, wird der Kennwert auf null (41) gesetzt und die Bildung der Summe erfolgt (42) dann.

3. Verfahren nach Anspruch 1 oder 2, wobei vor dem Vergleichen der Summe mit dem Lastgrenzwert geprüft wird, ob sich die Summe während eines ersten Zeitraums (51) erhöht hat, und wenn sich die Summe nicht erhöht hat, wird die Summe auf null (52) gesetzt, doch wenn sich die Summe erhöht hat, bleibt die Summe unverändert.

4. Verfahren nach Anspruch 3, wobei der erste Zeitraum in Abhängigkeit vom Kennwert (50) bestimmt wird.

5. Verfahren nach einem der Ansprüche 1 bis 4, wobei dann, wenn die Summe des Lastgrenzwert nicht erreicht oder unter ihn absinkt, bevor zum Start der Schleife zurückgekehrt wird, wird die Summe mit einem Messgrenzwert (71) verglichen, und wenn der Messgrenzwert vor der Rückkehr zum Start der Schleife überschritten wird, werden Maßnahmen unternommen, um den durchschnittlichen Strom, der durch das Relais oder den elektronischen Schalter (72) geleitet wird, zu reduzieren, während er dann, wenn der Messgrenzwert nicht erreicht wird, zum Start der Schleife (8) zurückgeführt wird.

6. Verfahren nach einem der Ansprüche 1 bis 5, wobei der Lastzeitraum für einen elektronischen Schalter als eine Funktion des thermischen Widerstands zwischen dem Übergang des elektronischen Schalters und der Umgebung bestimmt wird.

7. Schaltvorrichtung, umfassend ein Relais oder einen elektronischen Schalter, einen Stromsensor in dem Relais oder elektronischen Schalter oder außerhalb des Relais oder elektronischen Schalters, und eine Steuerung mit einem Ausgang, der mit einem Steuereingang des Relais oder elektronischen Schalters und einem mit dem Stromsensor verbundenen Eingang verbunden ist, wobei die Steuerung dazu angeordnet ist, das Verfahren nach einem der Ansprüche 1 bis 6 auszuführen.

**Revendications**

1. Méthode de protection des relais ou commutateurs électroniques contre la surchauffe ou les dommages dus à des courants de court-circuit rampants,
   dans laquelle les étapes suivantes sont exécutées en boucle

   - mesure du courant de court-circuit rampant à un moment de mesure donné (8),
   - détermination d'une période de charge (17) pendant laquelle le relais ou le commutateur pourrait continuer à être chargé par le courant de court-circuit rampant mesuré à partir du moment de mesure sans être endommagé ou détruit, sans tenir compte de la charge du relais ou du commutateur avant le début de la boucle,

- détermination d'une valeur caractéristique (32) correspondant au rapport entre la durée de l'intervalle de mesure et la période de la charge,
- détermination de la somme de la valeur caractéristique et d'une somme déterminée au cours d'une exécution précédente de la boucle (42),
- comparaison de la somme avec une valeur limite de charge (60),
- génération d'un signal indiquant qu'une valeur limite de charge a été atteinte si la somme atteint ou dépasse la valeur limite de charge (61),
- retour au début de la boucle si la somme n'a pas atteint ou est inférieure à la valeur limite de charge (71, 8).

2. Méthode selon la revendication 1, dans laquelle, avant de déterminer la somme, la durée de la période de charge est comparée à une valeur limite de temps (40) et, si la période de charge est inférieure à la valeur limite de temps, la détermination de la somme est effectuée (42) ou, si la période de charge est supérieure à la valeur limite de temps, la valeur caractéristique est mise à zéro (41) et la détermination de la somme est effectuée (42).

3. Méthode selon la revendication 1 ou 2, dans laquelle, avant de comparer la somme à la valeur limite de charge, on vérifie si la somme a augmenté au cours d'une première période de temps (51) et, si la somme n'a pas augmenté, la somme est mise à zéro (52) mais, si la somme a augmenté, la somme reste inchangée.

4. Méthode selon la revendication 3, dans laquelle la première période est déterminée en fonction de la valeur caractéristique (50).

5. Méthode selon l'une des revendications 1 à 4, dans laquelle, si la somme n'atteint pas ou est inférieure à la valeur limite de charge avant le retour au début de la boucle, la somme est comparée à une valeur limite de mesure (71) et, si la valeur limite de mesure est dépassée avant le retour au début de la boucle, des mesures sont prises pour réduire le courant moyen conduit à travers le relais ou le commutateur électronique (72), tandis que, si la valeur limite de mesure n'est pas atteinte, on revient au début de la boucle (8).

6. Méthode selon l'une des revendications 1 à 5, dans laquelle la durée de charge est déterminée pour un commutateur électronique en fonction de la résistance thermique entre la liaison entre le commutateur électronique et l'environnement.

7. Dispositif de commutation comprenant un relais ou un commutateur électronique, un capteur de courant à l'intérieur du relais ou du commutateur électronique ou à l'extérieur du relais ou du commutateur électronique, et un contrôleur ayant une sortie connectée à une entrée de commande du relais ou du commutateur électronique et une entrée connectée au capteur de courant, le contrôleur étant agencé pour exécuter la méthode selon l'une des revendications 1 à 6.

Fig. 1

Fig. 2

Fig. 3

Fig. 4

## Fig. 5

NVMFD5C446N - time vs. current

$y = -0,2645x^3 + 8,2495x^2 - 86,871x + 326,85$

## Fig. 6a

Current progression

· · · · · Ityp [A]  ——— I actual [A]  – – – short circuit current threshold [A]

Fig. 6b

Fig. 7a

Fig. 7b

Fig. 8a

EP 4 104 292 B1

Fig. 8b

EP 4 104 292 B1

Deactivation request for circuit (19)

Circuit active? (20) — No →

Time between current measurements = t_meas
Formula: Prog(t)[%]=t_meas/t_actual (30)

Calculate time progress of activated circuit (31)

% progress of time = Prog(t) (32)

t_actual < 250s ? (40) — No → Prog(t) = 0 (No limitation) (41)

Yes

1) Sum_Prog_t = Sum_Prog_t_old + Prog(t)
2) Sum_Prog_t_old = Sum_Prog_t (42)

TH_Protection = 70% (e.g.) (70)

t_unchanged (e.g.)
Sum_Prog_t <20% = 1s, <50% = 5s, <80% = 10s (50)

Sum_Prog_t changed since t_unchanged (51) → Sum_Prog_t =0 (reset of progress) (52)

Optional: protection routine (71) — No →

Sum_Prog_t >=100% (60) — No →

Yes

E.g. PWM, duty cycle adjustment... (72)

Set DTC (61)

Deactivate Circuit (90)

End (100)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015138682 A1

- US 2015022930 A1